# FASCICULE DE BREVET EUROPEEN

(11) **EP 4 228 994 B1**
(45) Date de publication et mention de la délivrance du brevet: **05.08.2026**
(21) Numéro de dépôt: 21801593.1
(22) Date de dépôt: 06.10.2021
(51) Int. Cl.: B81C 1/00

(54) **PROCEDE DE TRANSFERT D'UNE MEMBRANE**
MEMBRANTRANSFERVERFAHREN
MEMBRANE TRANSFER METHOD

(30) Priorité: 16.10.2020 FR 2010644
(43) Date de publication de la demande: 23.08.2023
(73) Titulaire: SOITEC, 38190 Bernin (FR)
(72) Inventeur: DARRAS, François-Xavier, 38190 Bernin (FR); GHYSELEN, Bruno, 38190 Bernin (FR)
(74) Mandataire: IP Trust
(86) Numéro de dépôt international: PCT/FR2021/051733
(87) Numéro de publication internationale: WO 2022/079374

(56) Documents cités:
- FR-A1- 3 079 616
- US-B2- 6 958 255
- M. PIJOLAT ET AL: "Mode conversion in high overtone bulk acoustic wave resonators", FREQUENCY CONTROL SYMPOSIUM, 2009 JOINT WITH THE 22ND EUROPEAN FREQUENCY AND TIME FORUM. IEEE INTERNATIONAL IEEE, PISCATAWAY, NJ, USA, 20 April 2009 (2009-04-20), pages 290 - 294, XP031492385, ISBN: 9781424435111, DOI: 10.1109/FREQ.2009.5168188

## Description

### DOMAINE DE L'INVENTION

La présente invention concerne le domaine de la microélectronique et des microsystèmes. Elle concerne en particulier un procédé de fabrication d'une structure comprenant une membrane ayant une caractéristique piézoélectrique susceptible de se déformer au-dessus d'au moins une cavité.

### ARRIERE PLAN TECHNOLOGIQUE DE L'INVENTION

Les dispositifs MEMS (MEMS pour l'acronyme anglais de « Microelectromechanical systems ») sont largement utilisés pour la fabrication de capteurs divers. Plusieurs de ces dispositifs MEMS ont comme principe de fonctionnement, la vibration d'une membrane flexible au-dessus d'une cavité. On peut citer par exemple, les microsystèmes de type PMUT (PMUT pour l'acronyme anglais de « Piezoelectric Micromachined Ultrasonic Transducer »). En fonctionnement, la vibration de la membrane générée par un paramètre physique, par exemple la propagation d'une onde acoustique, est convertie en un signal électrique (ou vice-versa selon que le dispositif est en mode récepteur ou émetteur).

Pour réaliser une structure à membrane suspendue sur cavités, plusieurs approches peuvent être adoptées. Une première approche consiste à démonter un substrat SOI (SOI pour l'acronyme anglais de « Silicon On Insulator ») préalablement collé à un substrat muni de cavités. Une autre approche comporte des étapes de dépôt et de libération de la membrane par attaque chimique.

La formation d'une membrane suspendue par dépôt sacrificielle a de nombreux inconvénients : le vide dans la cavité pourrait être limité, le risque de coller la membrane au fond de la cavité lors de la libération, le risque de libération partielle, la difficulté de gestion des contraintes mécaniques de la membrane, etc. Par ailleurs, la formation d'une membrane suspendue par collage d'un substrat SOI avant de le démonter par grinding/attaque chimique, permet de mieux maîtriser l'atmosphère de la cavité (scellée au moment du collage). Cependant, cette opération est relativement coûteuse puisqu'elle nécessite la consommation d'un substrat SOI.

Une autre alternative plus élégante, consiste à utiliser le transfert d'une couche directement sur les cavités par la technologie dite Smart-Cut^{™}, pour former la membrane suspendue.

Selon cette alternative, il s'avère difficile de transférer une membrane sur des cavités de grandes dimensions. Or, il y a un fort besoin de disposer de cavités de grandes dimensions. Notamment pour les dispositifs PMUTs dont les cavités mesurent généralement plusieurs centaines de microns de sorte que leur fréquence de fonctionnement ne soit pas trop haute et soit comprise entre 0,1 et 10 MHz.

Le brevet français FR2715502 décrit comment transférer une membrane suspendue sur des cavités par Smart-Cut. Selon cet enseignement, lorsque le substrat comportant les cavités est en silicium, la dimension (Lmax) des cavités doit être inférieure à 10 fois l'épaisseur (e0) de la membrane transférée. On entend par dimension de la cavité, la dimension latérale dans le plan principale de la face avant du substrat, par exemple une largeur, une longueur, un diamètre, etc.

Par ailleurs, le maximum d'épaisseur (e0) de la membrane à transférer selon un procédé de type Smart-Cut^{™} est limité par l'énergie d'implantation du substrat donneur, et ne peut dépasser de ce fait quelques microns. En effet, les implanteurs ioniques de forte énergie (>250keV) qui pourrait permettre d'implanter plus profondément ont des flux faibles et l'étape d'implantation ionique nécessiterait un temps conséquent. De ce fait, pour implanter les doses visées (plusieurs 10¹⁶cm⁻²), le procédé serait difficile à réaliser (lent) et couteux. De plus, ces équipements ne sont pas standards. Par conséquent, la dimension latérale maximale d'une cavité dans ce type de structure obtenue par Smart-Cut ne peut dépasser quelques dizaines de microns.

Les documents FR3079616 et US6958255 proposent des structures comprenant une couche mince transférée, formant une membrane à l'aplomb de cavités. Le document FR3079616 propose un procédé de type Smart-Cut.

L'état de l'art pertinent est également le suivant :
"Mode conversion in high overtone bulk acoustic wave resonators" par M. Pijolat et al., Frequency Control Symposium, 2009 Joint with the 22nd European frequency and time Forum. IEEE International IEEE, Piscataway, NJ, USA, 20 avril 2009 (2009-04-20), pages 290-294. Cet article de recherche décrit un procédé de transfert d'une couche mince piézoélectrique d'un substrat donneur vers un substrat récepteur par la technique Smart-Cut.

### OBJET DE L'INVENTION

La présente invention vise à pallier tout ou partie des inconvénients précités. Elle concerne un procédé de transfert par Smart-Cut d'une membrane à caractère piézoélectrique sur un substrat comprenant au moins une cavité de grande dimension.

A cet effet, l'invention concerne un procédé tel que défini en revendication 1.

Selon d'autres caractéristiques avantageuses et non limitatives de ce procédé de fabrication, prises seules ou selon toute combinaison techniquement réalisable :
∘ le substrat support est en silicium,
∘ le substrat donneur est en silicium et le dépôt de la couche raidisseur est réalisée à une température inférieure à 450 °C,
∘ le substrat donneur est en carbure de silicium et le dépôt de la couche raidisseur est réalisée à une température inférieure 850 °C,
∘ les espèces légères implantées sont des ions d'hydrogène et/ou d'hélium,
∘ une première couche électriquement conductrice est interposée entre la couche raidisseur et le substrat support, la première couche étant directement en contact avec la couche raidisseur et configurée pour former une électrode inférieure du dispositif,
∘ une couche de collage est interposée entre la couche raidisseur et le substrat support, ladite couche de collage étant directement en contact avec le substrat support, préférentiellement la couche de collage étant en oxyde de silicium,
∘ une deuxième couche électriquement conductrice est formée sur la couche raidisseur, la deuxième couche étant configurée pour former une électrode supérieure du dispositif,
∘ le procédé comprend au moins une rectification mécanique et/ou au moins un polissage mécano-chimique et/ou au moins une gravure chimique au niveau de la couche superficielle après l'étape e) de fracture.
∘ l'étape d) d'assemblage comprend le collage par adhésion moléculaire entre, d'une part, le substrat donneur muni de la couche raidisseur et d'autre part, la première face du substrat support.
∘ une étape de dépôt sur la surface libre de la couche superficielle est réalisée après l'étape e) de sorte à augmenter l'épaisseur de la couche superficielle.

Selon un autre aspect de l'invention, l'invention concerne également un substrat donneur configuré pour transférer une membrane à caractère piézoélectrique sur un substrat support muni d'au moins une cavité ayant une dimension latérale supérieure à 30 µm, tel que défini en revendication 13.

### BREVE DESCRIPTION DES FIGURES

D'autres caractéristiques et avantages de l'invention ressortiront de la description détaillée de l'invention qui va suivre en référence aux figures annexées sur lesquelles :
[Fig. 1]
   [Fig. 2]
   [Fig. 3]
   [Fig. 4]

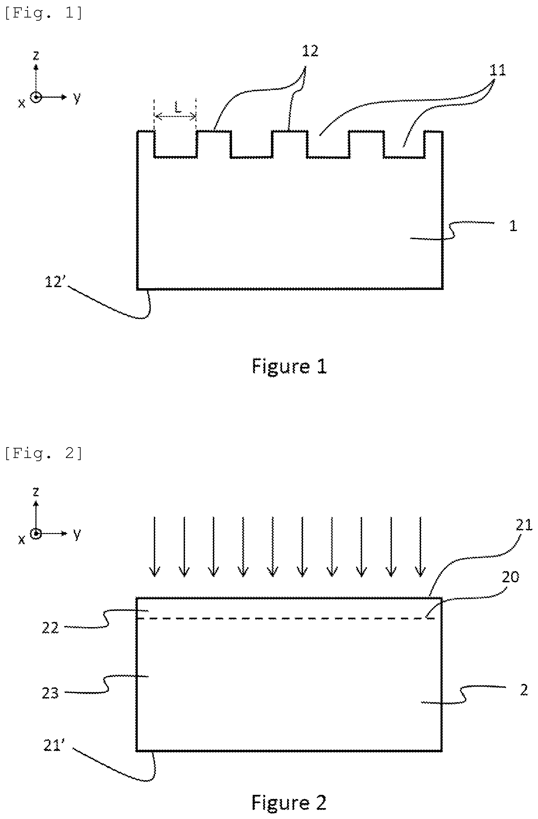

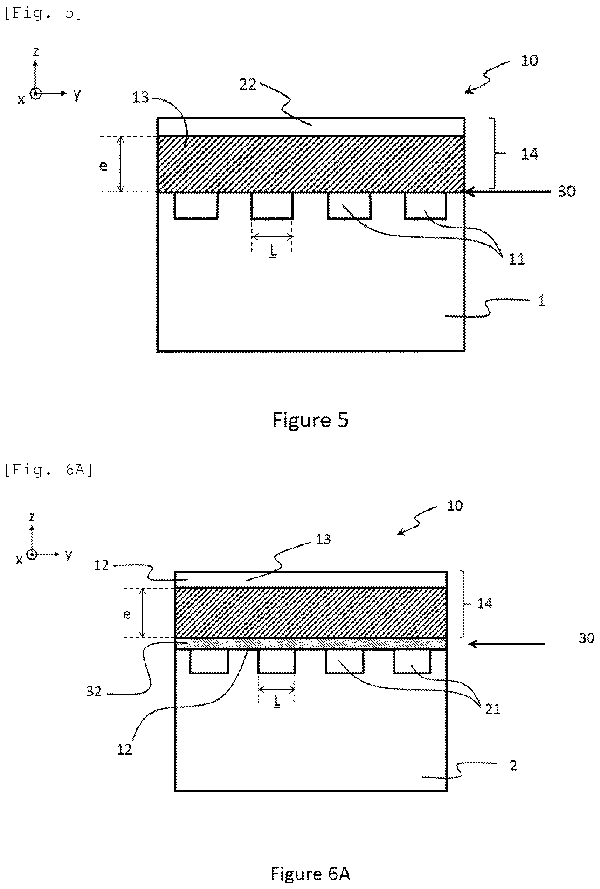

   [Fig. 5] Les figures 1 à 5 représentent des étapes d'un procédé de transfert d'une membrane disposée sur des cavités enterrées conforme à l'invention ;
[Fig. 6A]
   [Fig. 6B]
   [Fig. 6C]

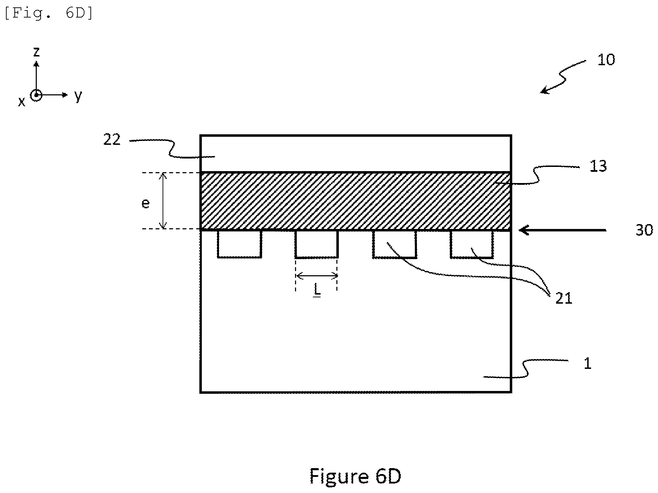

   [Fig. 6D] Les figures 6A à 6D représentent des variantes et d'autres étapes d'un procédé de transfert conforme à l'invention.

### DESCRIPTION DETAILLEE DE L'INVENTION

Dans la partie descriptive, les mêmes références sur les figures pourront être utilisées pour des éléments de même type. Les figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y ; et les épaisseurs relatives des couches entre elles ne sont pas nécessairement respectées sur les figures.

L'invention concerne un procédé de transfert d'une membrane 14 à caractère piézoélectrique sur un substrat support 1 comportant des cavités 11 (figures 1 à 5), ledit procédé de transfert visant la fabrication d'une structure 10 à cavités enterrées 11 de grande dimension.

Le procédé selon l'invention comprend une étape de fourniture du substrat support 1 (cf. figure 1) ; ce dernier présente une première face 12 destinée à être assemblée sur un substrat donneur 2 et une seconde face 12', dite face arrière, opposée à la première face 12. A titre d'exemple non limitatif, le substrat support 1 pourra comprendre du silicium, du verre, du saphir, etc. L'épaisseur du substrat support 1 peut être de l'ordre de quelques centaines de µm, typiquement 775 µm pour des substrats ayant un diamètre d'environ 300 mm.

Le substrat support 1 comporte une pluralité de cavités 11 débouchant au niveau de sa première face 12. Chaque cavité 11 présente un fond et des parois périphériques. Préférentiellement, le substrat support 1 est un substrat de silicium.

La géométrie de chaque cavité 11, qui dépend du dispositif visé, notamment du dispositif MEMS visé, est définie par :
- la forme de la cavité 11 dans le plan de la première face 12 du substrat support 1 (dit plan principal (x,y)) : elle pourra être circulaire, carré, rectangulaire ou polygonale ;
- les dimensions latérales L de la cavité 11, dans le plan principal (x,y) : elles pourront varier de quelques dizaines de microns à quelques millimètres ;
- la profondeur de la cavité 11, selon l'axe z normal au plan principal (x,y) : elle pourra varier de quelques centaines de nanomètres à quelques dizaines de microns, voire quelques centaines de microns.

Selon l'invention, le procédé de transfert concerne le transfert d'une membrane 14 à caractère piézoélectrique sur le substrat support 1 comportant les cavités enterrées 11 de grande dimension. Par grande dimension, on entend que la dimension latérale L dans le plan (x , y) des cavités 11 est supérieure à 30 µm.

La répartition planaire des cavités 11, c'est-à-dire leur répartition dans le plan principal (x , y) dépend également du dispositif visé et va définir l'espacement inter-cavités 11 : il pourra varier de quelques microns à quelques centaines de microns, voire à quelques millimètres. L'espacement inter-cavités pourra être uniforme et identique sur toute la surface du substrat support 1 ou varier selon les zones à la surface dudit substrat support 1.

Notons que le substrat support 1 pourra comporter des cavités 11 présentant des formes, dimensions latérales, profondeurs et/ou répartitions planaires différentes, en particulier s'il est prévu de co-intégrer des dispositifs de différents types sur la structure 10 à cavités enterrées.

Diverses couches pourront être déposées sur le fond et/ou sur les parois des cavités 11 (par exemple, en nitrure de silicium, en oxyde de silicium, etc.) selon le type de dispositif destiné à être élaboré sur la structure 10 à cavités enterrées 11.

Le procédé selon l'invention comprend également une étape de fourniture d'un substrat donneur 2 présentant une face avant 21, destinée à être assemblée sur le substrat support 1 et une face arrière 21' (cf. figure 2).

A titre d'exemple, et sans que cela soit limitatif, le substrat donneur 2 pourra comprendre au moins un matériau semiconducteur. Selon la présente invention, le substrat donneur 2 est un substrat de silicium ou un substrat en carbure de silicium (SiC).

L'étape de fourniture du substrat donneur 2 comprend également une étape d'implantation d'espèces légères dans ledit substrat donneur 2, à travers la face avant 21 de manière à former un plan de fragilisation 20 s'étendant entre une première partie du substrat donneur 1, destinée à former une couche superficielle 22, et une deuxième partie 23 destinée à constituer le reste du substrat donneur 2. Préférentiellement, les espèces légères implantées sont des ions d'hydrogène et/ou d'hélium.

L'énergie d'implantation des espèces légères (par exemple hydrogène et/ou hélium) conditionne l'épaisseur de la première partie, et donc de la future couche superficielle 22. Avantageusement, l'énergie d'implantation est choisie de sorte que la première partie du substrat donneur 2 présente une épaisseur de l'ordre de 0,2 micron à 2 microns.

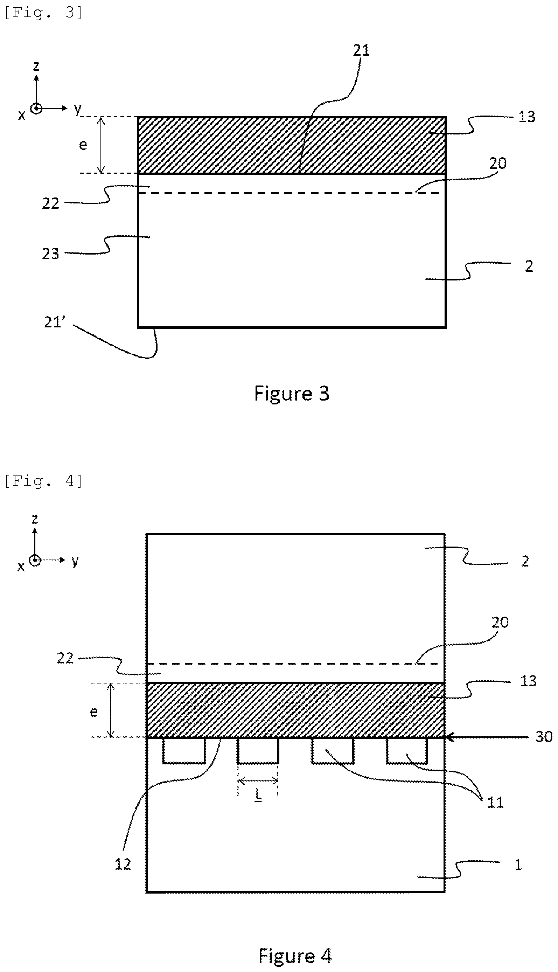

Par ailleurs, le procédé selon l'invention comporte en outre une étape de dépôt d'une couche raidisseur 13 en matériau ayant une caractéristique piézoélectrique, sur la face avant 21 du substrat donneur 2 (cf. figure 3). L'étape de dépôt est mise en œuvre après l'étape d'implantation ionique des espèces légères dans le substrat donneur 2. L'épaisseur e de la couche 13 est supérieure à 500 nm. De manière encore plus préférentielle, l'épaisseur e de la couche 13 est supérieure à 1 µm voire à 4 µm.

La couche raidisseur 13 peut comprendre un matériau choisi parmi le niobate de lithium (LiNbO3), le tantalate de lithium (LiTaO3), le niobate de potassium-sodium (KₓNa₁₋ₓNbO₃ ou KNN), le titanate de barium (BaTiO3), le quartz, le titano-zirconate de plomb ou PZT (Pb(Zr,Ti)O₃), un composé de niobate de plomb-magnésium et de titanate de plomb (PMN-PT) à proportions variables (par exemple 70/30 ou 90/10) selon les propriétés recherchées, l'oxide de zinc (ZnO), le nitrure d'aluminium (AlN) ou le nitrure d'aluminium et de scandium (AlScN), etc.

Préférentiellement, la couche raidisseur 13 est en AlN ou en PZT. En effet, ces deux matériaux sont considérés comme les matériaux piézoélectriques fréquemment utilisés dans le domaine des MEMS. Par ailleurs, le coefficient d'élasticité de l'AlN est de l'ordre de 300 GPa, et il est largement supérieur à celui du PZT. Ainsi, de manière encore plus préférentielle on choisira l'AlN comme matériau piézoélectrique de la couche raidisseur 13.

A titre d'exemple de mise en œuvre, lorsque la couche raidisseur 13 est en AlN et le substrat donneur 2 est en silicium muni de cavités ayant des dimensions latérales d'environ 50 µm, l'épaisseur de la couche raidisseur est préférentiellement supérieure ou égale à 1,5 µm. Selon un autre exemple de mise en œuvre semblable, dans lequel la couche raidisseur 13 est en PZT, alors l'épaisseur de la couche raidisseur 13 est choisie préférentiellement supérieure à 7,5 µm.

Par ailleurs, l'homme du métier saura choisir l'épaisseur de la couche raidisseur 13 en fonction des dimensions latérales L des cavités 11 et des propriétés mécaniques (par exemple le module de Young) de la couche raidisseur 13 de sorte à réussir le transfert de la membrane 14.

L'homme du métier saura également adapter la température de dépôt de la couche raidisseur 13 en fonction de la nature du substrat donneur 2 de sorte à éviter le phénomène de cloquage.

Autrement dit, la couche raidisseur 13 est avantageusement déposée à une température adaptée et configurée pour éviter le phénomène de cloquage (« blistering » en terminologie anglo-saxonne) pouvant être généré par le plan de fragilisation 20 sous l'effet d'un traitement thermique avec un budget thermique important.

En effet, l'implantation d'ions légers a pour effet de créer des défauts (de type lacunaires ou interstitiels) au niveau du plan de fragilisation 20. Ces défauts sont communément appelés platelets et ils ont une dimension de l'ordre d'une dizaine de nanomètres. L'effet de la température provoque une évolution de la population de ces défauts par mûrissement d'Ostwald, menant ainsi à l'apparition de microfissures ou de microcavités. Les ions légers implantés en sursaturation dans le substrat donneur 2 précipitent sous forme gazeuse dans ses microcavités sous l'effet de la température. Lorsqu'on applique un budget thermique important les cavités se développent alors verticalement et latéralement sous forme de bulles et coalescent en provoquant le phénomène de cloquage au niveau de la face avant 21.

Selon une variante de mise en œuvre, lorsque le substrat donneur 2 est en silicium (ou comportant une couche en silicium dans laquelle l'implantation des ions légers a été réalisée), la température de dépôt est préférentiellement inférieure à 450 °C, et encore plus préférentiellement inférieure à 400 °C.

Selon une autre variante de mise en œuvre, lorsque le substrat donneur 2 est en carbure de silicium (ou comportant une couche en carbure de silicium dans laquelle l'implantation des ions légers a été réalisée), la température de dépôt est préférentiellement inférieure à 850 °C.

La couche 13 peut être déposée par n'importe quelle technique connue de l'homme du métier, et compatible avec des procédés conventionnels dans le domaine de la microélectronique. Préférentiellement, la couche raidisseur 13 est déposée par pulvérisation cathodique ou par la technique dite sol-gel, une technique de dépôt chimique.

A titre d'exemple, le dépôt par pulvérisation cathodique permet avantageusement d'obtenir des couches piézoélectriques cristallisées pour des températures de dépôt faibles de l'ordre de 300 ou de 400 °C pour certains matériaux, tels que le nitrure d'aluminium (AlN).

Avantageusement, une couche raidisseur 13 piézoélectrique en AlN est déposée par pulvérisation cathodique selon l'invention.

Par ailleurs, le PZT est déposé par pulvérisation cathodique à des températures relativement plus élevées que celle du dépôt de l'AlN, pour être cristallisé. Les températures de dépôt du PZT peuvent atteindre 700 °C.

Selon un mode de réalisation de l'invention, une couche raidisseur 13 en PZT peut être déposée par le procédé sol-gel. Il s'agit d'une technique de dépôt chimique : les précurseurs à déposer sont introduits sous forme solide dans un solvant. La solution obtenue est alors étalée sur la face avant 21 du substrat donneur 2. L'étalement peut être réalisé par centrifugation (« spin coating » selon la terminologie anglo-saxonne). Le substrat est ensuite séché pour évaporer le solvant avant de subir une étape de calcination pour casser les chaines carbonées. L'enchainement des étapes étalement, séchage et calcination peut être répété plusieurs fois afin d'épaissir la couche obtenue. Par ailleurs, la couche obtenue est généralement de nature amorphe et nécessite une étape finale de traitement thermique de cristallisation/densification.

Selon un autre mode de réalisation, une couche raidisseur 13 en PZT peut être réalisée par dépôt chimique en phase vapeur de type MOCVD à basse température (MOCVD pour « Metalorganic chemical vapor deposition » selon la terminologie anglo-saxonne). En effet, il est connu que cette technique permet de déposer le PZT dans un état cristallin à des température pouvant être inférieure à 400 °C voire moins.

Selon un mode de réalisation de l'invention, le procédé comporte optionnellement un traitement thermique de guérison de la couche raidisseur 13 déposée. Ledit traitement thermique de guérison peut avantageusement servir à recristalliser partiellement ou totalement la couche raidisseur 13. Ce traitement peut également être mis à profit pour dégazer et/ou débarrasser la couche piézoélectrique déposée d'impuretés qui auraient pu être introduites dans la couche pendant, avant, ou après son dépôt. Selon une alternative, le traitement thermique peut comporter un recuit thermique pour améliorer la cristallinité de la couche 13 déposée.

Comme illustré à la figure 4, le procédé selon l'invention comporte en outre une étape d'assemblage des substrats support 1 et donneur 2. Les substrats support 1 et donneur 2 sont assemblés au niveau d'une interface de collage 30 disposée entre la première face 12 du substrat support 1 et la couche raidisseur 13 disposée sur la face avant 21 du substrat donneur 2.

Avantageusement, cette étape comprend le collage direct, par adhésion moléculaire entre : d'une part, la première face 12 du substrat support 1, et d'autre part, la couche raidisseur 13 du substrat donneur 2. Le principe de l'adhésion moléculaire, bien connu dans l'état de l'art ne sera pas décrit plus en détail ici. Notons qu'un très bon état de surface (propreté, faible rugosité, ...) des surfaces à assembler est requis, pour obtenir une bonne qualité d'assemblage.

Avantageusement, pour garantir une bonne qualité d'assemblage, l'étape d'assemblage comprend un nettoyage des surfaces à assembler du substrat donneur 2 (ici selon ce mode de réalisation la surface de la couche raidisseur 13) et du substrat support 1, préalablement à la mise en contact desdites surfaces. A titre d'exemple, une séquence classique utilisée en microélectronique, notamment pour des substrats à base de silicium, comprend un nettoyage à l'ozone, un nettoyage de type SC1 (« Standard Clean 1 ») et un nettoyage de type SC2 (« Standard Clean 2 »), avec des rinçages intercalés. Une activation des surfaces à assembler, par exemple par plasma, pourra également être réalisée avant la mise en contact, pour favoriser une forte énergie de collage entre lesdites surfaces.

Le procédé selon l'invention prévoit en outre une étape de fracture du substrat donneur 2 au niveau du plan de fragilisation 20 enterré, de sorte à transférer une membrane 14 comportant la couche superficielle 22 et la couche raidisseur 13 sur le substrat support 1. La fracture se produit au niveau du plan fragilisé enterrée 20, entre la couche superficielle 22 et le reste 23 du substrat donneur 2 (cf. figures 2, 4 et 5).

Par ailleurs, l'étape de fracture est, bien entendu, réalisée après l'étape d'assemblage du substrat support 1 et du substrat donneur 2 muni de la couche raidisseur 13. Il s'agit d'une étape de fracture conventionnelle selon le procédé Smart Cut.

Comme illustré à la figure 5, à l'issue de l'étape de fracture, on obtient une membrane 14 transférée sur le substrat support 1. Rappelons que le procédé Smart Cut permet avantageusement, l'obtention de couches minces présentant une excellente uniformité d'épaisseur. Ce critère peut être très intéressant pour certains dispositifs MEMS requérant des membranes flexibles présentant des épaisseurs contrôlées.

Cette fracture est préférentiellement réalisée au cours d'un traitement thermique à une température comprise entre quelques centaines de degrés et 950 °C. Préférentiellement, la fracture est mise en œuvre au cours d'un traitement thermique réalisée à une température inférieure à 700 °C lorsque le plan de fragilisation est disposé dans une couche en silicium du substrat donneur 2. Selon un autre mode de réalisation, la fracture est mise en œuvre au cours d'un traitement thermique réalisée à une température inférieure à 950 °C lorsque le plan de fragilisation est disposé dans une couche en carbure de silicium du substrat donneur 2.

Selon un mode de réalisation, l'étape de fracture pourra alternativement être assistée mécaniquement ou réalisée après le traitement thermique, au moyen d'une sollicitation mécanique.

Selon le mode de réalisation dans lequel la couche raidisseur 13 est en PZT déposé par sol-gel, le traitement thermique de fracture opéré à une température comprise entre 500 et 750 °C permettra avantageusement la fracture du substrat donneur et la recristallisation du PZT déposé. Autrement dit, le traitement thermique de fracture comporte également le traitement thermique de guérison de la couche PZT.

Après le transfert de la membrane 14 sur le substrat support 1, l'étape de fracture peut comprendre un traitement de finition visant à améliorer la qualité cristalline (élimination de défauts dans la couche), la qualité de surface (élimination de la rugosité résiduelle sur la surface libre de la couche 22) et/ou à modifier l'épaisseur de la couche superficielle 22. Ce traitement pourra inclure un ou plusieurs traitement(s) thermique(s), polissage(s) mécano-chimique(s), gravure(s) chimique(s), croissance épitaxiale, et/ou dépôt de couches additionnelles.

En effet, dans certains cas où l'épaisseur de la couche superficielle 22 transférée par le procédé Smart Cut est insuffisante, il est possible d'augmenter cette épaisseur en déposant une couche additionnelle sur la surface libre de la couche superficielle 22, par exemple par croissance épitaxiale ou autres méthodes de dépôt connues, au cours d'un traitement de finition évoqué ci-dessus (cf. figure 6D). La couche additionnelle est préférentiellement de même nature que la couche superficielle 22.

A l'issue du procédé selon l'invention, on obtient ainsi une structure 10 munie de cavités enterrées 11 de grande dimension, et d'une membrane 14 à caractère piézoélectrique (comportant la couche superficielle 22 et la couche raidisseur 13) surplombant la ou les cavités 11.

Le procédé selon l'invention est facile à mettre en œuvre et permet de manière avantageuse le transfert efficace d'une membrane sur un substrat support muni de cavités de grande dimension, des cavités ayant une dimension latérale supérieure à 30 µm. La membrane est transférée intégralement et bénéficie des avantages du procédé Smart Cut. En effet, la demanderesse a observé qu'une couche raidisseur ayant une épaisseur supérieure à 500 nm, permet d'augmenter l'effet raidisseur du substrat donneur, bien qu'elle soit de nature piézoélectrique et différente du substrat donneur. Ce qui permet avantageusement d'éviter les problèmes de cloquage et/ou de transfert partiel d'une membrane pouvant survenir lorsque le procédé Smart Cut fait intervenir un substrat support tapissé de cavités de grande dimension. Par transfert partiel, on entend qu'une portion de la membrane n'est pas transférée sur le substrat support après l'étape de fracture.

Par ailleurs, la couche raidisseur selon l'invention est de nature piézoélectrique. Ainsi, le procédé selon l'invention offre une solution élégante, facile à mettre en œuvre et efficace pour réaliser une membrane à caractère piézoélectrique sur un substrat à cavités de grande dimension, tout en bénéficiant des avantages du procédé Smart Cut. Autrement dit, la membrane transférée présente une excellente uniformité d'épaisseur, ce qui peut être très intéressant pour certains dispositifs MEMS requérant des membranes flexibles surplombant des cavités, et présentant des épaisseurs contrôlées. Notamment, la structure obtenue peut être utilisée pour réaliser des dispositifs PMUTs dont les cavités mesurent généralement plusieurs centaines de microns. Grâce aux bénéfices du procédé Smart Cut, du caractère piézoélectrique de la membrane transférée, et de la grande dimension des cavités du substrat support, le procédé selon l'invention permet d'obtenir une structure configurée pour la réalisation, notamment de dispositifs PMUTs ayant une fréquence de fonctionnement précise et uniforme.

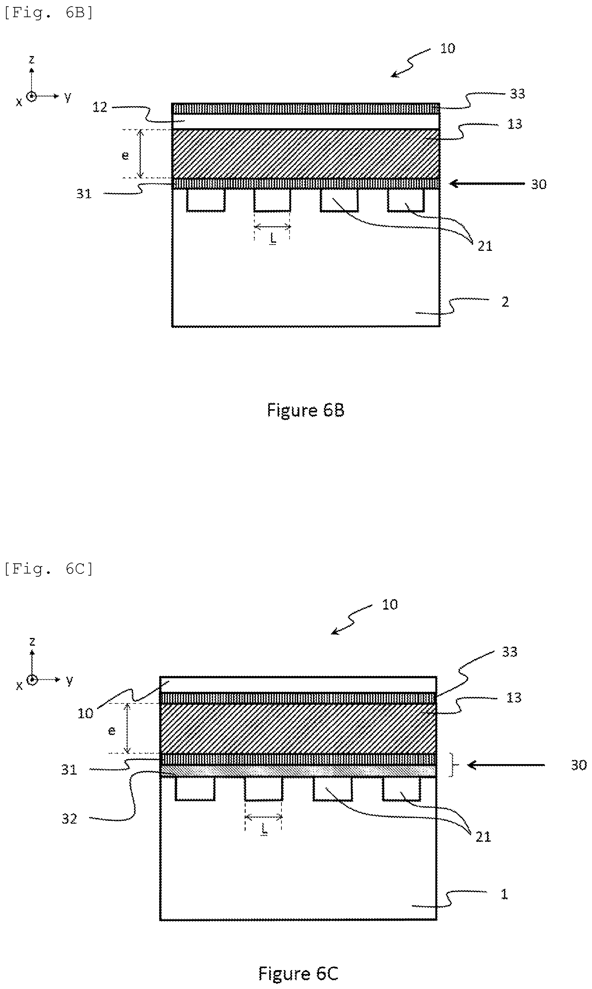

Selon un mode de réalisation illustré à la figure 6A, le substrat support 1 et/ou le substrat donneur 2 peuvent comprendre une couche de collage 32, respectivement au niveau de la première face 12 et/ou au-dessus de la couche raidisseur 13, pour favoriser la qualité de collage et l'énergie de collage de leur interface. La couche de collage 32 est préférentiellement disposée sur la couche raidisseur 13 de sorte que l'interface de collage 30 soit entre la première face 12 du substrat support 1 et ladite couche de collage 32 (cf. figures 6A et 6C). Avantageusement, la couche de collage 32 est en oxyde de silicium. En effet, l'oxyde de silicium est un matériau facile à déposer et permet d'obtenir une rugosité compatible avec un collage direct.

Préférentiellement, la couche de collage 32 est en oxyde de silicium et elle est formée par un dépôt PECVD de type TEOS (TEOS pour Tetraethyl orthosilicate). Après son dépôt, la couche d'oxyde peut être planarisée puis nettoyée pour la préparer à l'étape de collage direct, comme décrit ci-dessus.

En plus de la couche 32 configurée pour améliorer le collage, des couches supplémentaires peuvent être prévues notamment au niveau de la couche raidisseur 13. Les disposition, nature et fonction de ces couches seront détaillés ci-après.

Selon un mode de réalisation illustré à la figure 6B, une première couche 31 électriquement conductrice est interposée entre la couche raidisseur 13 et le substrat support 1. La première couche 31 est directement en contact avec la couche raidisseur 13 et elle est configurée pour former une électrode inférieure 31 du dispositif 10 réalisé à l'issue du procédé selon l'invention.

La première couche 31 peut être déposée après l'étape de dépôt de la couche raidisseur 13. Cette couche 31 peut être en platine (Pt), en Or (Au) en cuivre (Cu), en Molybdène ou encore en aluminium (Al). Par ailleurs, la première couche 31 peut être réalisée par n'importe quelle technique connue de l'homme du métier, et compatible avec des procédés conventionnels dans le domaine de la microélectronique. L'électrode inférieure 31 peut prendre avantageusement la forme d'un peigne interdigité.

A titre d'exemple, la première couche 31 peut être déposée par PVD (PVD pour l'acronyme anglosaxon de Physical Vapor Deposition). Le dépôt est préférentiellement réalisé à basse température (inférieure à 450°C). Pour le dépôt de la couche 31, des couches d'accroche et/ou barrière de diffusion peuvent être également prévues. Une couche d'accroche sert à améliorer la qualité de dépôt de la couche 31 sur le substrat donneur 2, notamment si la couche 31 est de nature métallique. Par ailleurs, une couche barrière de diffusion permet avantageusement d'éviter la diffusion des métaux dans la structure finale lors d'éventuelles étapes technologiques ultérieures.

Selon un mode de réalisation, lorsque la couche 31 est compatible avec un collage direct (niveau de rugosité suffisante), elle peut être collée directement sur le substrat support 1 (exemple collage direct Au/Au) . Dans ce cas, un collage par thermocompression peut être également envisagé.

Selon un mode de réalisation de l'invention dans lequel la couche de collage 32 est utilisée comme décrit auparavant, cette dernière peut être déposée sur la première couche 31.

Selon un autre mode de réalisation illustré à la figure 6B, une deuxième couche 33 électriquement conductrice est formée sur la couche superficielle 22. La deuxième couche 32 est directement en contact avec la couche superficielle 22 et elle est configurée pour former une électrode supérieure 32 du dispositif 10 réalisé à l'issue du procédé selon l'invention.

La deuxième couche 33 peut être déposée après l'étape de fracture (cf. figure 6B) ou avant le dépôt de la couche raidisseur 13 (cf. figure 6C). Cette couche 33 peut être en platine (Pt), en Or (Au) en cuivre (Cu), en Molybdène ou encore en aluminium (Al).

De manière préférentielle et comme illustré à la figure 6C, la couche 33 est déposée avant le dépôt de la couche raidisseur 13 de sorte qu'elle soit interposée, après l'étape de fracture, entre la couche superficielle 22 et la couche raidisseur 13. Selon ce mode de réalisation, les électrodes 31 et 33 sont avantageusement enterrées et sont donc passivées de sorte qu'elles soient moins sujettes à une oxydation ou une détérioration non souhaitées.

Par ailleurs, la deuxième couche 33 peut être réalisée de la même manière que la couche 31, autrement dit, par n'importe quelle technique connue de l'homme du métier, et compatible avec des procédés conventionnels dans le domaine de la microélectronique. En outre, les couches 31 et 33 peuvent avoir une épaisseur allant de quelques nanomètres à quelques dizaines de nanomètres.

L'invention concerne également un substrat donneur 2 configuré pour transférer une membrane 14 à caractère piézoélectrique sur un substrat support 1 comportant des cavités 11 de grande dimension (figures 1 à 5).

Comme illustré à la figure 3, le substrat donneur 2 comporte un substrat massif. Selon l'invention, le substrat donneur 2 est un substrat de silicium ou un substrat en carbure de silicium (SiC).

Le substrat donneur selon l'invention est muni d'un plan de fragilisation 20 s'étendant entre une première partie du substrat donneur 1, destinée à former une couche superficielle 22, et une deuxième partie 23 destinée à constituer le reste du substrat donneur 2. Le plan de fragilisation est formé par implantation d'espèces légères dans ledit substrat donneur 2. Préférentiellement, les espèces légères implantées sont des ions d'hydrogène et/ou d'hélium.

En outre, le substrat donneur 2 est muni d'une couche raidisseur 13 de nature piézoélectrique, disposée sur la face avant 21 du substrat donneur 2. L'épaisseur e de la couche 13 est supérieure à 500 nm. De manière encore plus préférentielle, l'épaisseur e de la couche 13 est supérieure à 1 µm voire à 4 µm.

La couche raidisseur 13 peut comprendre un matériau choisi parmi le niobate de lithium (LiNbO3), le tantalate de lithium (LiTaO3), le niobate de potassium-sodium (KₓNa₁₋ₓNbO₃ ou KNN), le titanate de barium (BaTiO3), le quartz, le titano-zirconate de plomb ou PZT (Pb(Zr,Ti)O₃), un composé de niobate de plomb-magnésium et de titanate de plomb (PMN-PT) à proportions variables (par exemple 70/30 ou 90/10) selon les propriétés recherchées, l'oxide de zinc (ZnO), le nitrure d'aluminium (AlN) ou le nitrure d'aluminium et de scandium (AlScN), etc.

Préférentiellement, la couche raidisseur 13 est en AlN ou en PZT.

La couche 13 peut être déposée par n'importe quelle technique connue de l'homme du métier, et compatible avec des procédés conventionnels dans le domaine de la microélectronique. Préférentiellement, la couche raidisseur 13 est déposée par pulvérisation cathodique ou par la technique dite sol-gel qui est une technique de dépôt chimique.

Le substrat donneur selon l'invention est avantageusement configuré pour transférer une membrane 14 formée par la couche raidisseur 13 et la couche superficielle 22 sur un substrat support 1 muni de cavités 11 de grande dimension (cf. figure 5). Le substrat donneur 2 selon l'invention, permet avantageusement le transfert d'une membrane offrant à la fois une caractéristique raidisseur pour réussir un transfert efficace de la membrane, et une caractéristique piézoélectrique pour la réalisation de dispositifs nécessitant ce type de matériau, notamment des dispositifs PMUTs.

## Revendications

1. Procédé de fabrication d'un dispositif (10) comportant une membrane (14) à caractère piézoélectrique surplombant au moins une cavité (11), le procédé comportant :
a) La fourniture d'un substrat support (1) présentant une première face (12) s'étendant selon un plan (x, y) et muni d'une cavité (11) débouchant au niveau de la première face (12), la cavité (11) ayant une dimension latérale dans le plan (x, y) supérieure à 30 µm,
b) La fourniture d'un substrat donneur (2) en silicium ou en carbure de silicium, muni d'un plan de fragilisation (20) enterré formé par une implantation d'espèces légers à travers une face avant (21) du substrat donneur (2), le plan de fragilisation (20) délimitant une couche superficielle (22), puis
c) Le dépôt sur la face avant (21) du substrat donneur (2) d'une couche raidisseur (13) en matériau piézoélectrique ayant une épaisseur (e) supérieure à 500 nanomètres,
d) L'assemblage des substrats support (1) et donneur (2) au niveau d'une interface de collage (30) disposée entre la première face (12) du substrat support (1) et la couche raidisseur (13),
e) La fracture, après l'étape d), du substrat donneur (2) au niveau du plan de fragilisation (20) enterré, de sorte à transférer une membrane (14) comportant la couche superficielle (22) et la couche raidisseur (13) sur le substrat support (1), la membrane (14) surplombant la cavité (11).

2. Procédé selon la revendication 1, dans lequel le substrat support (1) est en silicium.

3. Procédé selon la revendication 1, dans lequel le substrat donneur (2) est en silicium et le dépôt de la couche raidisseur (13) est réalisée à une température inférieure à 450 °C.

4. Procédé selon la revendication 1, dans lequel le substrat donneur est en carbure de silicium et le dépôt de la couche raidisseur (13) est réalisée à une température inférieure 850 °C.

5. Procédé selon l'une des revendications précédentes, dans lequel les espèces légères implantées sont des ions d'hydrogène et/ou d'hélium.

6. Procédé selon l'une des revendications précédentes, dans lequel une première couche (31) électriquement conductrice est interposée entre la couche raidisseur (13) et le substrat support (1), la première couche (31) étant directement en contact avec la couche raidisseur (13) et configurée pour former une électrode inférieure (31) du dispositif (10).

7. Procédé selon l'une des revendications précédentes, dans lequel une couche de collage (32) est interposée entre la couche raidisseur (13) et le substrat support (1), ladite couche de collage (32) étant directement en contact avec le substrat support (1).

8. Procédé selon la revendication précédente, dans lequel la couche de collage (32) est en oxyde de silicium.

9. Procédé selon l'une des revendications précédentes, dans lequel une deuxième couche (33) électriquement conductrice est formée sur la couche raidisseur (13), la deuxième couche (33) étant configurée pour former une électrode supérieure (33) du dispositif (10).

10. Procédé selon l'une des revendications précédentes, comprenant au moins une rectification mécanique et/ou au moins un polissage mécano-chimique et/ou au moins une gravure chimique au niveau de la couche superficielle (22) après l'étape e) de fracture.

11. Procédé selon l'une des revendications précédentes, dans lequel l'étape d) d'assemblage comprend le collage par adhésion moléculaire entre, d'une part, le substrat donneur (2) muni de la couche raidisseur (3) et d'autre part, la première face (12) du substrat support (1).

12. Procédé selon l'une des revendications précédentes, dans lequel une étape de dépôt sur la surface libre de la couche superficielle (22) est réalisée après l'étape e) de sorte à augmenter l'épaisseur de la couche superficielle (22).

13. Substrat donneur (2) configuré pour transférer une membrane (14) à caractère piézoélectrique sur un substrat support muni d'au moins une cavité ayant une dimension latérale supérieure à 30 µm, le substrat donneur (2) étant en silicium ou en carbure de silicium et comportant :
un plan de fragilisation (20) disposé dans le substrat donneur (2) et délimitant une couche superficielle (22), et une couche raidisseur (13) en matériau piézoélectrique ayant une épaisseur (e) supérieure à 500 nanomètres disposée sur la couche superficielle (22).

## Patentansprüche

1. Verfahren zur Herstellung einer Vorrichtung (10) mit einer piezoelektrischen Membran (14), die über mindestens einen Hohlraum (11) ragt, das Verfahren umfassend:
a) Bereitstellung eines Trägersubstrats (1) mit einer ersten Oberfläche (12), die sich in einer Ebene (x, y) erstreckt und mit einem Hohlraum (11) versehen ist, der in die erste Oberfläche (12) mündet, wobei der Hohlraum (11) eine seitliche Abmessung in der Ebene (x, y) von mehr als 30 µm aufweist,
b) Bereitstellung eines Donorsubstrats (2) aus Silizium oder Siliziumkarbid, das mit einer vergrabenen Schwächungsebene (20) versehen ist, die durch die Implantation von leichten Ionen durch eine Vorderseite (21) des Donorsubstrats (2) gebildet wird, wobei die Schwächungsebene (20) eine Oberflächenschicht (22) begrenzt, und anschließend
c) Das Aufbringen einer Versteifungsschicht (13) aus piezoelektrischem Material mit einer Dicke (e) von mehr als 500 Nanometern auf die Vorderseite (21) des Donorsubstrats (2),
d) Das Verbinden des Trägersubstrats (1) und des Donorsubstrats (2) an einer Klebefläche (30), die zwischen der ersten Oberfläche (12) des Trägersubstrats (1) und der Versteifungsschicht (13) angeordnet ist,
e) Das Brechen des Donorsubstrats (2) nach Schritt d) entlang der verborgenen Schwächungsebene (20), um eine Membran (14) mit der Oberflächenschicht (22) und der Versteifungsschicht (13) auf das Trägersubstrat (1) zu übertragen, wobei die Membran (14) über den Hohlraum (11) vorspringt.

2. Verfahren nach Anspruch 1, wobei das Trägersubstrat (1) aus Silizium besteht.

3. Verfahren nach Anspruch 1, wobei das Donorsubstrat (2) aus Silizium besteht und die Abscheidung der Versteifungsschicht (13) bei einer Temperatur unter 450 °C erfolgt.

4. Verfahren nach Anspruch 1, wobei das Donorsubstrat aus Siliziumkarbid besteht und die Abscheidung der Versteifungsschicht (13) bei einer Temperatur unter 850 °C erfolgt.

5. Verfahren nach einem der vorstehenden Ansprüche, wobei es sich bei den eingebauten leichten Spezies um Wasserstoff- und/oder Heliumionen handelt.

6. Verfahren nach einem der vorstehenden Ansprüche, wobei eine erste elektrisch leitende Schicht (31) zwischen der Versteifungsschicht (13) und dem Trägersubstrat (1) angeordnet ist, wobei die erste Schicht (31) in direktem Kontakt mit der Versteifungsschicht (13) steht und so ausgebildet ist, dass sie eine untere Elektrode (31) der Vorrichtung (10) bildet.

7. Verfahren nach einem der vorstehenden Ansprüche, wobei zwischen der Versteifungsschicht (13) und dem Trägersubstrat (1) eine Klebeschicht (32) angeordnet ist, wobei die Klebeschicht (32) in direktem Kontakt mit dem Trägersubstrat (1) steht.

8. Verfahren nach dem vorstehenden Anspruch, wobei die Klebeschicht (32) aus Siliziumoxid besteht.

9. Verfahren nach einem der vorstehenden Ansprüche, wobei auf der Versteifungsschicht (13) eine zweite elektrisch leitende Schicht (33) ausgebildet ist, wobei die zweite Schicht (33) so ausgebildet ist, dass sie eine obere Elektrode (33) der Vorrichtung (10) bildet.

10. Verfahren nach einem der vorstehenden Ansprüche, umfassend mindestens einen mechanischen Schleifvorgang und/oder mindestens einen mechanisch-chemischen Poliervorgang und/oder mindestens einen chemischen Ätzvorgang an der Oberflächenschicht (22) nach dem Bruchschritt e).

11. Verfahren nach einem der vorstehenden Ansprüche, wobei der Montageschritt d) das Verkleben durch molekulare Adhäsion zwischen dem mit der Versteifungsschicht (3) versehenen Donorsubstrat (2) einerseits und der ersten Oberfläche (12) des Trägersubstrats (1) andererseits umfasst.

12. Verfahren nach einem der vorstehenden Ansprüche, wobei nach Schritt e) ein Abscheidungsschritt auf der freien Oberfläche der Oberflächenschicht (22) durchgeführt wird, um die Dicke der Oberflächenschicht (22) zu erhöhen.

13. Spendersubstrat (2), das dazu ausgelegt ist, eine piezoelektrische Membran (14) auf ein Trägersubstrat zu übertragen, das mit mindestens einer Vertiefung versehen ist, deren seitliche Abmessung größer als 30 µm ist, wobei das Spendersubstrat (2) aus Silizium oder Siliziumkarbid besteht und Folgendes umfasst:
eine im Donorsubstrat (2) angeordnete Schwächungsebene (20), die eine Oberflächenschicht (22) begrenzt, und eine auf der Oberflächenschicht (22) angeordnete Versteifungsschicht (13) aus piezoelektrischem Material mit einer Dicke (e) von mehr als 500 Nanometern.

## Claims

1. A method for manufacturing a device (10) comprising a piezoelectric-nature membrane (14) overhanging at least one cavity (11), the method comprising:
a) Providing a support (1) substrate having a first face (12) extending in a plane (x, y) and provided with a cavity (11) opening at the first face (12), the cavity (11) having a lateral dimension in the plane (x, y) greater than 30 µm,
b) Providing a donor (2) substrate made of silicon or silicon carbide, provided with a buried embrittlement plane (20) formed by implanting light species through a front face (21) of the donor (2) substrate, the embrittlement plane (20) delimiting a superficial layer (22), and then
c) Depositing over the front face (21) of the donor (2) substrate a stiffener layer (13) made of a piezoelectric material having a thickness (e) greater than 500 nanometres,
d) Assembling the support (1) and donor (2) substrates at a bonding interface (30) disposed between the first face (12) of the support (1) substrate and the stiffener layer (13),
e) Fracturing, after step d), the donor (2) substrate at the buried embrittlement plane (20), so as to transfer a membrane (14) comprising the superficial layer (22) and the stiffener layer (13) onto the support (1) substrate, the membrane (14) overhanging the cavity (11).

2. The method according to claim 1, wherein the support (1) substrate is made of silicon.

3. The method according to claim 1, wherein the donor (2) substrate is made of silicon and depositing the stiffener layer (13) is carried out at a temperature below 450 °C.

4. The method according to claim 1, wherein the donor substrate is made of silicon carbide and depositing the stiffener layer (13) is carried out at a temperature lower than 850 °C.

5. The method according to one of the preceding claims, wherein the implanted light species are hydrogen and/or helium ions.

6. The method according to one of the preceding claims, wherein a first electrically conductive layer (31) is interposed between the stiffener layer (13) and the support (1) substrate, the first layer (31) being in direct contact with the stiffener layer (13) and configured to form a lower electrode (31) of the device (10).

7. The method according to one of the preceding claims, wherein a bonding layer (32) is interposed between the stiffener layer (13) and the support (1) substrate, said bonding layer (32) being in direct contact with the support (1) substrate.

8. The method according to the preceding claim, wherein the bonding layer (32) is made of silicon oxide.

9. The method according to one of the preceding claims, wherein a second electrically conductive layer (33) is formed on the stiffener layer (13), the second layer (33) being configured to form an upper electrode (33) of the device (10).

10. The method according to one of the preceding claims, comprising at least one mechanical grinding and/or at least one chemical mechanical polishing and/or at least one chemical etching at the superficial layer (22) after the fracturing step e).

11. The method according to one of the preceding claims, wherein the assembly step d) comprises bonding the donor (2) substrate provided with the stiffener layer (3), on the one hand, and the first face (12) of the support (1) substrate, on the other hand, by molecular adhesion.

12. The method according to one of the preceding claims, wherein a step of depositing onto the free surface of the superficial layer (22) is performed after step e) so as to increase thickness of the superficial layer (22).

13. A donor (2) substrate configured to transfer a piezoelectric-nature membrane (14) onto a support substrate provided with at least one cavity having a lateral dimension greater than 30 µm, the donor (2) substrate being made of silicon or silicon carbide and comprising:
an embrittlement plane (20) disposed in the donor (2) substrate and delimiting a superficial layer (22), and a stiffener layer (13) made of a piezoelectric material having a thickness (e) greater than 500 nanometres disposed over the superficial layer (22).
